# EUROPEAN PATENT APPLICATION

(11) **EP 1 834 728 A1**
(43) Date of publication of application: **19.09.2007**
(21) Application number: 05822361.1
(22) Date of filing: 27.12.2005
(51) Int. Cl.: B23K 35/363, B23K 35/22, H05K 3/34, B23K 35/26, C22C 13/00

(54) **LEAD-FREE SOLDER FLUX AND SOLDER PASTE**

(30) Priority: 28.12.2004 JP 2004380624; 13.05.2005 JP 2005141909
(71) Applicant: ARAKAWA CHEMICAL INDUSTRIES, LTD., Osaka-shi, Osaka 541-0046 (JP)
(72) Inventor: ISHIGA, Fumio c/o R & D Center of ARAKAWA, Tsurumi- ku, Osaka-shi, Osaka (JP); CHIBA, Yasuo c/o R & D Center of ARAKAWA CHEMICAL, Tsurumi-k u, Osaka-shi, Osaka; 5380053 (JP); KAJITA, Kazushige c/o R & D Center of ARAKAWA, Tsur umi-ku, Osaka-shi, Osaka; 5380053 (JP)
(74) Representative: Vossius & Partner
(86) International application number: PCT/JP2005/023890
(87) International publication number: WO 2006/070797

(57) **Abstract**

A flux for a lead-free solder that is able to reduce "void(s) appear within solder joint", "void(s) appear within solder joint", and "solder-balling" without impairing general solderabilities. The flux for a lead-free solder comprising 6-55 wt% of a polyvalent alcohol ester of a resin acid (a1) as a base resin (A). Further, a solder paste comprising the said flux for a lead-free solder and a lead-free solder powder provides a very small number of void(s) or a very small amount thereof.

## Description

### TECHNICAL FIELD

The present invention relates to a flux for a lead-free solder (hereinafter sometimes abbreviated as flux) and a solder paste containing the flux.

### BACKGROUND ART

For the purpose of mounting electronics parts such as a condenser on a surface of a conducting wire pattern on a circuit substrate board, soldering is generally conducted. In soldering, various characteristics are required. For instance, prevention of forming "solder ball" is important. The solder ball means such a phenomenon that a solder paste printed on a conducting wire pattern excessively slumps on a surface upon melting by reflow heating whereby fine ball-shaped solders are formed around peripheral positions of the slumped solder paste. When the number of the solder ball is large, for example, bridging and electrical shorts are likely to generate, whereby reliability of the mounted substrate board is extremely damaged.

By the way, recently lead co-crystalline solder which has conventionally been the main fashion has been replaced with a solder containing no lead (so-called a lead-free solder) for the reason why lead gives pollution to the environment and human body. According thereto, there is newly caused such a problem that micrometer level void(s) appear within solder joints, because the maximum heating temperature of a reflow furnace is increased by the temperature ranging from 40 to 50°C. Said voids are particularly easily generated within bump-joints in flip chip mounting substrate board (FC). When the number of the "void(s) appear within solder joint" or a diameter thereof is large, the strength either of the said bump-joints or of bump-metal layer is lowered, whereby reliability of mounting substrate is extremely damaged.

Further, a lead-free solder typified by Sn-Ag type one is not easily wetted to a base substrate board in a molten state, particularly to a copper type metal substrate board or to a ceramic substrate board under melting. For this reason, millimeter level void(s) may appear at the interface between solder and metal. The void may be observed in, particularly, direct bonding solder joint. Reliability of the mounted substrate board is also damaged by the void.

Under such situation as above, when a lead-free solder is used, various problems such as "solder ball", "void(s) appear within solder joint", and "void(s) appear at the interface of solder-metal" have to be solved.

In order to solve the "solder ball" problem, there has so far been known such a technology as using a specific amount of a polyvalent alcohol ester of a resin acid as a base resin of flux. For instance, (Japanese Patent No. 3513513 (Japanese Patent Publication No. JP7-185882A), Japanese Patent No. 3345138 (Japanese Patent Publication No. JP7-1182A), Japanese Patent No. 2561452 (Japanese Patent Publication No. JP5-337688A) and Japanese Patent Publication No. JP2002-361483A) are referred. However, those technologies cannot sufficiently solve the problem of "void(s) appear within solder joint" among others.

Further, in order to solve the problem of "void(s) appear within solder joint", there has been known, for instance, a technology of using a resin acid having a specific softening point and acid value as a base resin of flux (for instance, Japanese Patent Publication Nos. JP2003-264367A, JP9-10988A, etc. are referred). However, the effect is not sufficient.

Still further, for the purpose of solving the problem of "void(s) appear at the interface of solder-metal", selecting the kind of an activator as a flux material has been general (for instance, Japanese Patent Publication No. JP10-178261A is referred). However, its effect is not sufficient, so that the choice of materials in formulating flux tends to be restricted.

### DISCLOSURE OF INVENTION

An object of the present invention is to provide a flux for a lead-free solder that is able to reduce "void(s) appear within solder joint" and "void(s) appear at the interface of solder-metal" (hereinafter, sometimes, referred to as "void" collectively), and "solder-balling" without impairing general solderabilities.

Another object is to provide a solder paste comprising the said flux that provides a very small number of void(s) or a very small amount thereof when soldering.

The present inventors have considered that one of the reasons for generation of "void(s) appear within solder joint" may be as follows. Namely, the present inventors have assumed that the generation of voids is due to (1) an extreme increase of a temperature of a reflow furnace necessary in soldering with a lead-free solder, (2) decomposition of the resin acids as the base resin of the flux results in generating a gas within solder joints by this temperature rise. The said gas is considered to be a volatile cyclic compound produced by the elimination of a tertiary carboxylic group from the resin acids.

Further, the present inventors have assumed that the generation of "void(s) appear at the interface of solder-metal" is due to the remainders of low molecular weight substances, which is contained in the resin acids as the base resin of the flux in a large amount, generated at the solder joint interface between molten solder and base substrate board (ceramic, etc.).

On the basis of the above considerations, the present inventors have found that the "void(s) appear within solder joint" can be solved with a flux containing a specific amount of an ester composition excellent in thermal stability, which is obtained by reacting a resin acid with a polyvalent alcohol, as the base resin.

Further, the present inventors have found that "void(s) appear at the interface of solder-metal" can be solved with a flux containing "an ester composition wherein the ingredients having a molecular weight of equal to or less than 300 are previously removed until an amount thereof is reduced down to a specific amount (wt%) in relation to its softening point (K)" as the base resin, or with a flux comprising "a resin acid wherein the ingredients having a molecular weight of equal to or less than 300 are previously removed until an amount thereof is reduced down to a specific amount (wt%) in relation to its softening point (K)" as the ester composition or the resin acid used as the base resin (hereinafter, sometimes, "the ingredients having a molecular weight of equal to or less than 300" is simply referred to as "low boiling point ingredients").

Namely, the present invention relates to a flux for a lead-free solder, which comprises 6-55 wt% of a polyvalent alcohol ester of a resin acid (a1) as a base resin (A).

Preferably, the above ester (a1) is prepared to have a ratio (wt%/K) equal to 0.004 or less, wherein the (wt%) is a content weight of components having a molecular weight equal to 300 or less in the ester (a1), and the (K) is a softening point of the same ester (a1).

Preferably, the resin acid constitutes the above ester (a1) is a Diels-Alder adduct of an α, β-unsaturated carboxylic acid and a resin acid.

Preferably, the base resin (A) further comprises a resin acid (a2).

Preferably, the above resin acid (a2) is prepared to have a ratio (wt%/K) equal to 0.004 or less, wherein the (wt%) is a content weight of components having a molecular weight equal to 300 or less in the resin acid (a2), and the (K) is a softening point of the same resin acid (a2).

Preferably, the above resin acid (a2) comprises a polymerized rosin and/or a Diels-Alder adduct of an α,β-unsaturated carboxylic acid and a resin acid.

Preferably, a total solid content weight of the above ester (a1) and the above resin acid (a2) is 10-60 wt%.

Preferably, a solid content weight of the said ester (a1) in a total solid content weight of the above ester (a1) and the above resin acid (a2) is 60-88 wt%

Preferably, the flux for a lead-free solder further comprises an activator (B), an additive (C) and a solvent (D).

Preferably, the above polyvalent alcohol is a di- or more valent alcohol.

Preferably, the above polyvalent alcohol is a trivalent alcohol and/or a tetravalent alcohol.

Preferably, the above polyvalent alcohol is glycerin and/or pentaerythritol.

The present invention also relates to a solder paste which comprises the above flux for a lead-free solder and a lead-free solder powder.

### BEST MODE FOR CARRYING OUT THE INVENTION

The flux of the present invention comprises an ester (a1) obtained by an esterification reaction of a resin acid and a polyvalent alcohol, as the essential ingredients as a base resin (A).

The resin acid constructuring the ester (a1) is exemplified by a known natural rosin such as gum rosin, a wood rosin and a tall oil rosin, and various derivatives of the said natural rosins. The natural rosins and their derivatives may be used singly or in combination.

The said natural rosin mainly comprises resin acids such as abietic acid, levopimaric acid, neoabietic acid, parastric acid, pimaric acid, isopimaric acid, sandaracopimaric acid and dehydroabietic acid.

And the said natural rosin has an acid value of generally around 160-190 mgKOH/g, preferably around 170-180 mgKOH/g (measured according to JIS-K5902. Hereinafter the unit is omitted), and a softening point of generally around 340-450 K, preferably around 345-383 K (softening point is one obtained by converting the value (°C) measured according to JIS-K5903 into the absolute temperature (K), hereinafter the same is adopted).

The said derivative is exemplified by a disproportionated product, a hydrogenated product, a dehydrogenated product, a formylated product, a polymerized product (polymerized rosin), etc. of the said natural rosin, and a Diels-Alder adduct of an α,β-unsaturated carboxylic acid to a resin acid (hereinafter referred to as "Diels-Alder adduct"), etc.

Further, the said derivative has an acid value of generally around 140-400, preferably around 145-380, and a softening point of generally around 340-480 K, preferably around 373-443 K.

The above polymerized rosin is a composition containing around 30-80 wt% dimerized resin acid, and has an acid value of generally around 100-300, preferably around 140-170, and has a softening point of generally around 363-450 K, preferably around 373-440 K. The polymerized rosin can also commercially be available, for instance "CP-No.140 (Wuping Luzhou Forestry and Chemical Industry Co., Ltd.)", "TX295 (Arizona Chemical Co., Ltd.)", etc.

The above Diels-Alder adduct is a composition containing a compound which is obtained by Diels-Alder reaction of an α,β-unsaturated carboxylic acid and a resin acid contained in the resin acid.

The said α,β-unsaturated carboxylic acid can be exemplified by various conventional ones, including an α,β-unsaturated monocarboxylic acid such as acrylic acid and methacrylic acid, and an α,β-unsaturated dicarboxylic acid such as crotonic acid, itaconic acid, maleic acid, maleic anhydride, fumaric acid, comunic acid and citraconic acid, and their neutralized salts.

A compound used for said neutralized salt is exemplified by various conventional ones, such as an organic base, for instance, ammonia, ammonium carbonate, monoethylamine, monobutylamine, dimethylamine, dibutylamine, trimethylamine, diethylamine, etc. and a salt of a metal such as calcium, sodium and potassium. Considering that the flux of the present invention is applied for electronic materials, the organic base is preferable as the said neutralized salt.

The said Diels-Alder adduct is a composition, which has an acid value of generally around 20-400, preferably around 100-380, still preferably 200-360, and a softening point of generally 363-453 K, preferably around 373-443 K, still preferably 383-433 K.

The said Diels-Alder adduct can also be commercially available as, for example, "Pinecrystal series", "KE series", "MALKYD series", etc. (all are manufactured by Arakawa Chemical Industries, Ltd).

The ester (a1) is a composition obtained by reacting the above resin acid with a polyvalent alcohol, and contains an ester compound excellent in thermal stability.

As the polyvalent alcohol constructing the ester (a1), various conventional ones can be used. For example, there can be exemplified by a divalent aliphatic alcohol such as ethylene glycol, diethylene glycol, triethylene glycol, tripropylene glycol, 1,2-dihydroxy propane, 1,3-dihydroxy propane, 1,2-dihydroxy butane, 1,3-dihydroxy butane, 2,3-dihydroxy butane, neopentyl glycol, 1,4-bis-hidroxymethyl-cyclohexane, 1,6-hexane diol, octen glycol and polyethylene glycol, a bisphenol such as 2,2-bis (4-hydroxyphenyl) methane, 2,2-bis (4-hydroxyphenyl) propane, 2,2-bis (4-hydroxy-3-methylphenyl) propane, 2,2-bis (4-hydroxy-3-t-butylphenyl) propane, 2,2-bis (4-hydroxy-3,5-dimethylphenyl) propane, 2,2-bis (4-hydroxy-3,5-dibromo) propane, 4,4-bis (4-hydroxyphenyl) heptane and 1,1-bis (4-hydroxyphenyl) cyclohexane, a biphenol such as 4,4'-dihydrosxybiphenyl and 3,3',5,5'-tetramethyl-4,4'-biphenyl, a divalent aromatic alcohol such as 4,4'-isopropylidenediphenol (bisphenol A), bis (4-hydroxyphenyl) sulfone (bisphenol S), bis (4-hydroxyphenyl) ether, bis (4-hydroxyphenyl) ketone and 4,4'-dihydroxybiphenyl, a divalent alicyclic alcohol corresponding to the said divalent aromatic alcohol, etc. Those can be used singly or in combination of two or more thereof. The trivalent alcohol is exemplified by a trivalent aliphatic alcohol such as glycerine, glycerol, 1,2,3-propane triol, 1,2,4-butane triol, 3-methylpentane-1,3,5-triol, 1,2,6-hexane triol and 1,3,5-tris (2-hydroxyethyl) cyanuric acid, etc. Those can be used singly or in combination of two or more thereof. The tetravalent alcohol is exemplified by a tetravalent aliphatic alcohol such as diglycerine and pentaerythritol. Those can be used singly or in combination of two or more thereof. As the penta- or more valent alcohol, dipentaerythritol, for example, can be used.

Among the polyvalent alcohol, the above divalent alcohol is preferable from a viewpoint of suppressing the void (particularly the above "void(s) appear within solder joint"). Particularly, the above trivalent alcohol and/or tetravalent alcohol are preferable. Specifically, the above glycerine and/or pentaerythritol are preferable.

As the ester (a1), an ester using the above adduct as the resin acid, or an ester using glycerine and/or pentaerythritol as the polyvalent alcohol or both is preferable. The said ester (a1) is less crystalline than the resin acid, and thus the solder paste used thereof as a flux base becomes excellent in its quality control and in little viscosity change over time, for example.

The method for producing the ester (a1) is not specifically restricted and various conventional ones can be utilized. Specifically, it can be obtained, for example, by reacting the above resin acid and above polyvalent alcohol at around 150-300°C by removing water, until the characteristics of resultant reaches the desired ones as mentioned below. The reaction is generally conducted under normal pressure.

In addition, the reaction is preferably conducted under an inert gas stream such as nitrogen gas and a rare gas. The weight ratio of the resin acid and above polyvalent alcohol is calculated by the molar equivalent ratio of them, that is, (COOH(eq):OH(eq)) ranges generally from 1:1.5 to 1:0.7. In the esterification reaction, an esterification catalyst can be used. Specifically, an acid catalyst such as acetic acid and p-toluene sulfonic acid, a metal hydroxide of an alkali metal such as lithium hydroxide, sodium hydroxide and potassium hydroxide, a metal hydroxide of an alkaline earth metal such as calcium hydroxide and magnesium hydroxide, a metal oxide of an alkaline earth metal such as calcium oxide and magnesium oxide can be exemplified. Those can be used singly or in combination of two or more thereof. The resin acid as the starting material for the ester (a1) may be one previously treated by various purification methods as mentioned below.

Thus obtained ester (a1) is a composition containing an ester compound in an amount of generally around 98-90 wt%, preferably around 95-92 wt%. The acid value thereof is generally around 0.1-50, preferably around 0.1-25, still preferably 1-20. The softening point thereof is generally around 343-453 K, preferably around 353-443 K, still preferably 363-433 K. The hydroxyl value thereof is generally around 0-60, preferably around 1-40.

The content weight (wt%) of the above ester compound in the ester (a1) can be determined by measuring after a conventional manner such as gas chromatography. So far as the said content weight can substantially be determined, other GPC devices and columns can be also used. More conveniently, the content weight (wt%) is determinable by dividing the acid value of the ester (a1) by the acid value of the resin acid using as the starting material.

As mentioned above, the above low boiling point ingredient is considered to be one factor of forming the voids.

Thus, in the present invention, the voids can effectively be reduced by using an ester (a1') as the base resin (A), which is a product prepared by various purification means as mentioned below to have a ratio (wt%/K) equal to or less than 0.004, preferably equal to or less than 0.002, still preferably equal to or less than 0.001, particularly preferably equal to or less than 0.0001, most preferably substantially 0, wherein the (wt%) is a content weight of the low boiling point ingredient in the purified ester (a1), and the (K) is a softening point thereof. Considering a balance between the effect of suppression of voids and either purification time or product cost, the ratio (wt%/K) may be equal to 0.000001 or more, preferably equal to 0.00001 or more.

The low boiling point ingredient includes the above volatile cyclic compounds, and remaining such as catalysts, non-reacted substances, impurities, etc. Those have low boiling points or low melting points, and thus when those remain in a large amount in the ester (a1), voids tend to generate easily.

In the present invention, each of the content weight (wt%) of the said low boiling point ingredient and the softening point (K) is not specifically restricted so far as the above ratio (wt%/K) does not exceed 0.004. For instance, when the softening point (K) of the ester (a1) after the treatment is 373 K, the content weight of the low boiling point ingredient can be equal to 1.5 wt% or less, preferably equal to 0.4 wt% or less. Further, when the softening point of the ester (a1) after the treatment is, for instance, 433 K, the content weight of the low boiling point ingredient can be equal to 1.7 wt% or less, preferably equal to 0.8 wt% or less.

It is not clear the reason why the void is reduced with an ester (a1) having said ratio (wt%/K). It may possibly be considered that a high softening point of the ester (a1) make the motion of the above low boiling point ingredient difficult in a solder paste whereby the effect of suppressing voids even when the content weight of the said low boiling point ingredients in relation with the softening point (K) is relatively large. On the other hand, it may possibly be considered that a low softening point of the ester (a1) makes the motion of the above low boiling point ingredient easy in a solder paste whereby the effect of suppressing voids can be attained by lowering the low boiling point ingredient relatively to the softening point (K).

In the present invention, the above ester (a1) and ester (a1') can be used together.

The purification method is exemplified by conventional methods such as (1) a reduced pressure-distillation method of heating under reduced pressure, (2) a water vapor distillation method of blowing heated water vapor into a reaction system under normal or reduced pressure and (3) a solvent extraction method of using a solvent into which the low boiling point ingredients are effectively dissolved. Those methods can be combined suitably.

The above reduced pressure-distillation method (1) can be conducted, for example, at temperatures of generally around 200-300°C under a pressure of around 0.01-3 kPa. A treating time depends upon the temperature and pressure, and it is not specifically restricted so far as it is until the above ratio becomes 0.004 or less. The specific conditions are, for instance, 270°C and 0.5 kPa for around 1 hour. Purification effect can be further heightened by using a molecular distillation method using a molecular distillation membrane as the reduced pressure-distillation method.

The above water vapor distillation method (2) can be conducted, for instance, generally around 200-300°C under a normal pressure by blowing a water vapor under a pressure around 0.1-1 Mpa into a reaction system. The treating time depends upon the temperature, pressure and conditions for blowing water vapor, and it is not specifically restricted so far as it is until the above ratio becomes 0.004 or les. Specifically, for instance, a water vapor around 0. 1 MPa is blown into a reaction system around 270°C under a normal pressure for about 2 hours.

The above solvent extraction method (3) can be conducted, for example, by crushing the above ester (a1) and then making extraction with a solvent, which can suitably dissolve the above low boiling point ingredients. The solvent is exemplified by an aliphatic hydrocarbon such as hexane and heptane, and an alcohol such as methanol and ethanol.

The ester (a1) generally has a wide range softening point, and thus the higher the softening point is, the larger the viscosity of the distillation system becomes, as a result, the low boiling point ingredients hardly escape therefrom. On the other hand, the lower the softening point is, the smaller the viscosity thereof becomes, as a result, the ingredients easily escape therefrom. Therefore, the time for the distillation is depends on the softening point of the ester (a1)

The content weight (wt%) of the low boiling point ingredients in the ester (a1) can generally be determined by a peak surface area ratio obtained by means of gel permeation chromatography (GPC). Specifically, for example, it can be determined by dividing a total peak surface area of the low boiling point ingredients by a total peak surface area of the above ester (a1). Measuring conditions of GPC are not restricted.

The obtained ester (a1') is a composition containing generally around 98-90 wt%, preferably around 95-92 wt% of the ester compound, and has an acid value generally around 0.1-50, preferably around 0.1-25, still preferably 0.5-20, a softening point generally around 343-453 K, preferably around 348-448 K, still preferably 353-443 K, and has a hydroxyl value generally around 0-60, preferably around 1-45. The content weight (wt%) of the ester compound in the ester (a1') can be determined by the similar manner as the above ester (a1).

Each of the ester (a1) and ester (a1') can be subjected further to various kinds of conventional treatments, such as hydrogenation treatment, disproportionation treatment, dehydrogenation treatment, treatment with adding an antioxidant, etc. Such treatments are favorable because thermal stability and coloring of the flux can be improved.

The flux of the present invention contains the ester (a1) and/or (a1') in an amount generally around 6-55 wt% for the purpose of reducing generation of the above voids (particularly "void(s) appear within solder joint"). When the content weight (wt%) is less than 6 wt%, it becomes difficult to reduce the void, and when the content weight (wt%) is more than 55 wt%, general solderabilities tend to be impaired, for example, solder ball(s) tend to appear.

For those reasons, the said content weight is preferably around 9-45 wt%, still preferably 18-40 wt%.

The resin acid (a2) as a base resin (A) can be the same resin acid of ester (a1). The resin acid (a2) mainly removes surface oxidizes of a lead-free solder powder with its active carboxylic group.

The said resin acid (a2) is preferably one containing the above polymerized rosin and/or Diels-Alder adduct because they have relatively high softening points and thus improve both the anti-oxidation property and thermal stability of the flux.

In the present invention, the voids can effectively be reduced by using a resin acid (a2) as a base resin (A), which is a product prepared by various purification means as mentioned above to have a ratio (wt%/K) equal to or less than 0.004, preferably equal to or less than 0.002, still preferably equal to or less than 0.001, particularly preferably equal to or less than 0.0001, most preferably substantially 0, wherein the (wt%) is a content weight of the low boiling point ingredient in the purified resin acid (a1), and the (K) is a softening point thereof. Considering a balance the effect of suppression of voids and either purification time or product cost, the ratio (wt%/K) may be 0.000001 or more, preferably 0.00001 or more.

The low boiling point ingredient is the same as above. When a large amount of the said low boiling point ingredients is contained in the resin acid (a2) after treatment, voids tend to generate easily.

In the present invention, each of the content weight (wt%) of the said low boiling point ingredient and softening point (K) is not specifically restricted so far as the above ratio (wt%/K) is not out of 0.004.

It is not clear the reason why the void is reduced with resin acid (a2) having said ratio (wt%/K). It may possibly be considered that a high softening point of the resin acid (a2) make the motion of the above low boiling point ingredient difficult in a solder paste whereby the effect of suppressing voids even when the content weight of the said low boiling point ingredients in relation with the softening point (K) is relatively large. On the other hand, it may possibly be considered that a low softening point of the resin acid (a2) makes the motion of the above low boiling point ingredient easy in a solder paste whereby the effect of suppressing voids can be attained by lowering the low boiling point ingredient relatively to the softening point (K).

The above purification means (1) to (3) can be used, and those can be used in combination.

The resin acid (a2) generally has a wide range softening point, and thus the higher the softening point is, the larger the viscosity of the distillation system becomes, as a result, the low boiling point ingredients hardly escape therefrom. On the other hand, the lower the softening point also is, the smaller the viscosity thereof becomes, as a result, the ingredients easily escape therefrom. Therefore, the time for the distillation depends on the softening point of the resin acid (a2).

The obtained resin acid (a2'), if it is one obtained by purifying the above natural rosin, it has an acid value generally around 160-190, preferably around 170-180, and has a softening point generally around 340-450 K. And if it is one obtained by purifying the various derivative of the above natural rosin, it has an acid value generally around 140-400, and has a softening point generally around 340-480 K.

The resin acid (a2) and the resin acid (a2') can be used together.

Each of the resin acid (a2) and resin acid (a2') can be subjected to various conventional treatments, such as hydrogenation treatment, disproportionation treatment, treatment of adding an antioxidant, etc. Such treatments are favorable because thermal stability and coloring of the flux can be improved.

In the present invention, other base resin can be used as a base resin (A); specifically, there are exemplified by a synthetic resin including an epoxy resin, an acryl resin, a polyimide resin, a polyamide resin (a nylon resin), a polyester resin, a polyacrylonitrile resin, a vinyl chloride resin, a vinyl acetate resin, a polyolefin resin, a fluorine type resin, an ABS resin, etc.; a synthetic rubber including an isoprene rubber, a styrene butadiene rubber (SBR), a butadiene rubber (BR), a chloroprene rubber, a nylon rubber; an elastomer including a nylon elastomer, a polyester elastomer, etc.; an ester, which is normally liquid, obtained from the above resin acid and a monoalcohol (for instance, methyl alcohol, ethyl alcohol, butyl alcohol, etc.). Those can be used singly or in combination of two or more thereof. Those can be used generally in an amount around 0-20 wt% relative to the total weight of the solid content of the base resin (A).

When the above ester (a1) (preferably (a1')) and resin acid (a2) (preferably (a2')) are used together in the present invention, the total solid content weight of the both is generally around 10-60 wt%, preferably around 6-40 wt%, still preferably 6-30 wt% from a viewpoint of reducing the voids.

In this case, the solid content weight of the ester (a1) (preferably ester (a1')) in the total solid content weight of the above ester (a1) (preferably ester (a1')) and resin acid (a2) (preferably resin acid (a2')) is generally around 60-88 wt%, preferably around 70-85 wt%, still preferably 73-82 wt% from a viewpoint of reducing the voids.

As the activator (B), a conventional activator for a flux can be used. Specifically, for example, as an organic acid type compound activated in preheating in a reflow treatment, there are exemplified by succinic acid, benzoic acid, adipic acid, abietic acid, glutaric acid, palmitic acid, stearic acid, formic acid, azelaic acid; as an organic amine type compound activated in preheating in a reflow treatment, there are exemplified by tributylamine, dioctylamine, dibutylamine, etc. Further, as a halogen compound activated in main heating in a reflow treatment, there are exemplified by ethylamine hydrochloride, methylamine hydrochloride, ethylamine hydrobromide, diethylamine hydrobromide, methylamine hydrobromide, propene diol hydrochloride, allylamine hydrochloride, 3-amino-1-propene hydrochloride, N-(3-aminopropyl) methacrylamide hydrochloride, O-anisidine hydrochloride, n-butylamine hydrochloride, p-aminophenol hydrochloride, trans-2,3-dibromo-2-butene-1,4-diol, etc. Further, as a compound activated from preheating to main heating in reflow treatment, there are exemplified by quaternary ammonium, lauryl trimethyl ammonium chloride, an alkylbenzyldimethyl ammonoium chloride, tetrabutyl ammonium bromide, etc. The activator (B) can be used singly or in combination of two or more thereof. An amount of the activator (B) in the flux is generally around 0.1-10 wt%, preferably around 0.1-5 wt%, still preferably 0.1-3 wt%. By adjusting the amount to 0.1-10 wt%, soldering characteristics are improved, and storage stability and electrical insulation of a solder paste tend to be increased.

As the additive (C), various conventional antioxidants, thixotropic agents, anti-solidifying agents, anti-crusting agents, etc. can be used. As the antioxidants, 2,6-di-t-butyl-p-cresol, p-tert-aminophenol, 2,2'-methylene bis (4-methyl-6-tert-butylphenol), etc. are exemplified. As the thixotropic agents, castor oil, hydrogenated castor oil, bee wax, carnauba wax, stearic amide, hydroxy stearic amidethylene bisamide, etc. are exemplified. As the anti-solidifying agents and anti-crusting agents, an acetylene alcohol compound including 3-methyl-1-butyn-3-ol, 3-methyl-1-pentyn-3-ol, 3,5-dimethyl-1-hexyn-3-ol, 2,5-dimethyl-3-hexyn-2,5-diol, 2,4,7,9-tetramethyl-5-decyn-4,7-diol, 3,6-dimethyl-4-octyn-3,6-diol, etc. are exemplified (referred to Japanese Patent Publication No. JP2000-263281A). The "solidifying" or "crusting" generally means a phenomenon that solder paste changes in viscosity or becomes crusty or solid due to the reaction between lead-free solder powder and an activator etc. The additive (C) can be used singly or in combination of two or more thereof. An amount of the additive (C) to be added to the flux is generally around 0.1-10 wt%, preferably around 0.1-5 wt%, still preferably 0.1-2 wt%. When a thixotropic agent is used as the additive (C), its amount to be added to a flux is adjusted to generally around 3-20 wt%, preferably 4-10 wt. By adjusting the amount to be contained to around 3-20 wt%, generation of "cold slumping" and "coverage defect" can be suppressed. Further, when an acetylene alcohol compound is used as the additive (C), an amount to be added in a flux is adjusted to generally around 0.1-5 wt%, preferably 0.5-3 wt%. By adjusting an amount to be added to a flux to around 0.1-5 wt%, the effect of suppressing the above solidifying and crusting tend to be sufficient. When the amount is over 5 wt%, no additional effect is observed, and even the soldering characteristics tend to be lowered.

As the solvent (D), various conventional solvents so far been usable in a flux can be used without specific restriction. Specifically, there are exemplified by the following; an alcohol including ethylene glycol monohexyl ether, diethylene glycol monobutyl ether, hexyl glycol, octane diol, ethylhexyl glycol, benzyl alcohol, 1,3-butane diol, 1,4-butane diol-2-(2-n-butoxyethoxy) ethanol, terpineol, etc.; an ester including butyl benzoate, diethyl adipate, 2-(2-n-butoxyethoxy) ethylacetate, etc.; a hydrocarbon including dodecane, tetradecene, etc.; a pyrrolidone compound including N-methyl-2-pyrrolidone, etc. Those solvent (D) can be used singly or in combination of two or more thereof. As mentioned above, lead free solder has an extremely high melting point, therefore, the solvent (D) having a boiling point around 150-300°C, preferably around 220-280°C is desirable. A content weight of the solvent (D) to be added in a flux is generally around 20-85 wt%, preferably 25-85 wt%, still preferably 30-80 wt%. By adjusting the content weight to around 20-85 wt%, it becomes easy to improve printability and to reduce cold slumping.

The flux of the present invention can be obtained by kneading the base resin (A), the activator (B), additive (C) and solvent (D) by a conventional manner. In this process, the conditions (temperature, pressure, etc.) of kneading are not specifically restricted. As the kneading manner, a planetary mill, etc. can be used.

The solder paste of the present invention is a creamy composition obtained by kneading the above flux and various conventional lead-free solder powder with a conventional kneading means such as a planetary mill.

The lead-free solder powder is exemplified by Sn solder powder, Sn-Ag type solder powder, Sn-Cu type solder powder, Sn-Zn type solder powder, Sn-Sb type solder powder, etc., including specifically Sn-Ag solder powder, Sn-Ag-Cu solder powder, Sn-Ag-Bi solder powder, Sn-Ag-CU-Bi solder powder, Sn-Ag-Cu-In solder powder, Sn-Ag-Cu-S solder powder, Sn-Ag-Cu-Ni-Ge solder powder, etc. The flux of the present invention is directed to use as a lead-free solder, and according to the situation, it can be used also for a conventional lead co-crystalline. The lead-eutectic crystal solder powder is exemplified by Sn-Pb type solder powder, Sn-Pb-Ag type solder powder, Sn-Pb-Bi type solder powder, In-Pb type solder powder, Pb-Ag type solder powder, etc.

A solid weight ratio of the flux to the lead-free solder powder is generally around 5:95 to 20:80, preferably 9:91 to 20:80. Also in a case of the lead-eutectic crystal solder powder, the same can be adopted. In this way, good viscidity tends to be obtained.

The above additive (C) and solvent (D) and still other additives can optionally be used when preparing the solder paste.

### EXAMPLE

In the following, the present invention is further explained in more specifically referring to Examples, but the present invention is not limited thereby by any means.

### (Preparation of the ester (a1') and resin acid (a2'))

### PREPARATION METHOD 1

A commercial polymerized rosin ester (product name "Pensel D-160": Arakawa Chemical Industries, Ltd.) (it is the ester made from a polymerized rosin and pentaerythritol; it has an acid value of 13, a hydroxyl value of 40 and a softening point of 428 K, and contains 3.0 wt% of ingredient having a molecular weight of 300 or less, and has the ratio {the content weight (wt%) of an ingredient having a molecular weight equal to or less than 300 therein / a softening point (K) thereof} of 0.007) (hereinafter, the ester is referred to as an ester (a1-1) was added in a reactor equipped with an agitator, a water separator and a nitrogen-introduction tube, and then it was melted at 280°C. Then, reduced-pressure distillation was carried out under 0.5 kPa for 1 hour, and then the ester (a1'-1) was obtained. It has an acid value of 13, a hydroxyl value of 41, and a softening point of 442 K, and contains 1.7 wt% of ingredients with a molecular weight of 300 or less of, and has the ratio {the content weight (wt%) of an ingredient having a molecular weight equal to or less than 300 therein / a softening point (K)} thereof) of 0.0038. The content weight of ingredients having a molecular weight of 300 or less in each of the ester (a1-1) and the ester (a1'-1) was measured by a GPC analysis (apparatus: TOSOH K.K. product name: "HLC-8120", column: three columns of TOSOH K.K. "TSKge1SuperHM-L"). The properties thereof are shown in Table 1. The analysis was conducted in the same manner in Preparation Method 2 and thereafter.

### PREPARATION METHOD 2

Ester (a1'-2) was obtained by the same manner as in Preparation Method 1 under same conditions, except that a commercially available disoproportionated rosin ester (trade name "Super ester T-125": Arakawa Chemical Industries, Ltd, the ester composition of a disproportionated rosin and pentaerythritol) (hereinafter referred to as ester (a1-2), was used instead of the above commercially available polymerized rosin ester. The characteristics of the ester (a1-2) and ester (a1'-2) are shown in Table 1.

### PREPARATION METHOD 3

Ester (a1'-3) was obtained by the same manner as in Preparation Method 2, excepting adjusting time of distillation under reduced pressure to 2 hours. The characteristics, etc. are shown in Table 1.

### PREPARATION METHOD 4

Ester (a1'-4) was obtained by the same manner as in Preparation Method 2, excepting adjusting time of distillation under reduced pressure to 3 hours. The characteristics, etc. are shown in Table 1.

### PREPARATION METHOD 5

Ester (a1'-5) was obtained by the same manner as in Preparation Method 4, excepting using a commercially available rosin ester (product name "Pensel AD": Arakawa Chemical Industries, Ltd., the ester of a rosin and pentaerythritol) (hereinafter referred to as ester (a1-5)) in place of the above commercially available disproportionated rosin ester. The characteristics, etc. are shown in Table 1.

### PREPARATION METHOD 6

Ester (a1'-6) was obtained by the same manner as in Preparation Method 1, excepting using a commercially available rosin ester (product name "Pinecrystal KE-100": Arakawa Chemical Industries, Ltd., the ester of a disproportionated rosin and glycerine) (hereinafter referred to as ester (a1-6)) in place of the above commercially available polymerized rosin ester. The characteristics, etc. are shown in Table 1.

### PREPARATION METHOD 7

Ester (a1'-7) was obtained by the same manner as in Preparation Method 1, excepting using the ester of a disproportionated rosin and glycerin (hereinafter referred to as ester (a1-7)) in place of the above commercially available rosin ester. The characteristics, etc. are shown in Table 1.

### PREPARATION METHOD 8

Ester (a1'-8) was obtained by the same manner as in Preparation Method 1, excepting using commercially available rosin ester (product name "Ester gum RE": Arakawa Chemical Industries, Ltd., the ester of a disproportionated rosin and glycerin) (hereinafter referred to as an ester (a1-8)) in place of the above commercially available polymerized rosin ester. The characteristics, etc. are shown in Table 1.

### PREPARATION METHOD 9

Ester (a1'-9) was obtained by the same manner as in Preparation Method 1, excepting using the ester of an acrylic acid addition pale colored rosin (product name "KE-604": Arakawa Chemical Industries, Ltd.) and glycerin (hereinafter referred to as ester (a1-9)) in place of the above commercially available polymerized rosin ester. The characteristics, etc. are shown in Table 1.

### PREPARATION METHOD 10

The same reactor as in Preparation Method 1 was charged with 100 parts of the above commercially available polymerized rosin (hereinafter referred to as resin acid (a2-1), and the distillation under reduced pressure was conducted under the same conditions to give a resin acid (a2'-1). The characteristics, etc. are shown in Table 1.

### PREPARATION METHOD 11

In the same reactor as in Preparation Method 1 was charged with 100 parts of the commercial Diels-Alder adduct of an acrylic acid addition pale colored rosin (product name "KE-604": Arakawa Chemical Industries, Ltd.) (hereinafter referred to as resin acid (a2-2), and the distillation under reduced pressure was conducted under the same conditions to give a resin acid (a2'-2). The characteristics, etc. are shown in Table 1.

### COMPARATIVE EXAMPLES 1 to 9

Esters or resin acids themselves shown in Table 1 were used.

**TABLE 1**

| | Name | Product name | Moiety of ester compound | | AV | OHV | (wt%) | (K) | (wt%/K) |
|---|---|---|---|---|---|---|---|---|---|
| | | | Resin acid | Polyvalent alcohol | | | | | |
| Preparation Method 1 | (a1'-1) | Pencel D-160 | polymerized rosin | pentaerythritol | 13 | 41 | 1.7 | 442 | 0.0038 |
| Preparation Method 2 | (a1'-2) | Super Ester T-125 | disproportionated rosin | pentaerythritol | 18 | 10 | 1.5 | 396 | 0.0038 |
| Preparation Method 3 | (a1'-3) | Super Ester T-125 | disproportionated rosin | pentaerythritol | 17 | 10 | 1.0 | 398 | 0.0025 |
| Preparation Method 4 | (a1'-4) | Super Ester T-125 | disproportionated rosin | pentaerythritol | 16 | 10 | 0.6 | 400 | 0.0015 |
| Preparation Method 5 | (a1'-5) | Pencel AD | rosin | pentaerythritol | 12 | 34 | 0.4 | 381 | 0.0010 |
| Preparation Method 6 | (a1'-6) | KE-100 | disproportionated rosin | glycerine | 7 | 6 | 0.7 | 380 | 0.0018 |
| Preparation Method 7 | (a1'-7) | - | disproportionated rosin | glycerine | 0.9 | 10 | 0.8 | 378 | 0.0021 |
| Preparation Method 8 | (a1'-8) | Ester gum RE | disproportionated rosin | glycerine | 6 | 27 | 0.3 | 374 | 0.0008 |
| Preparation Method 9 | (a1'-9) | - | acrylic acid addition pale colred rosin | glycerine | 3.5 | 22 | 1.2 | 416 | 0.00288 |
| Preparation Method 10 | (a2'-1) | - | polymerized rosin | - | 149 | - | 0.8 | 420 | 0.0019 |
| Preparation Method 11 | (a2'-2) | KE-604 | acrylic acid addition pale colred rosin | - | 230 | - | 0.7 | 408 | 0.0017 |
| Comparative Example 1 | (a1-1) | Pencel D-160 | polymerized rosin | pentaerythritol | 13 | 40 | 3.0 | 428 | 0.0070 |
| Comparative Example 2 | (a1-2) | Super Ester T-125 | disproportionated rosin | pentaerythritol | 15 | 10 | 1.9 | 393 | 0.0048 |
| Comparative Example 3 | (a1-5) | Pencel AD | rosin | pentaerythritol | 14 | 35 | 3.5 | 353 | 0.0099 |
| Comparative Example 4 | (a1-6) | KE-100 | disproportionated rosin | glycerine | 8 | 6 | 1.7 | 374 | 0.0045 |
| Comparative Example 5 | (a1-7) | - | disproportionated rosin | glycerine | 0.3 | 8.5 | 1.8 | 375 | 0.0048 |
| Comparative Example 6 | (a1-8) | Ester gum RE | disproportionated rosin | glycerine | 5.6 | 35 | 1.7 | 367 | 0.0046 |
| Comparative Example 7 | (a1-9) | - | acrylic acid addition rosin | glycerine | 4.5 | 27 | 3.5 | 416 | 0.00841 |
| Comparative Example 8 | (a2-1) | - | polymerized rosin | - | 142 | - | 4.0 | 413 | 0.0097 |
| Comparative Example 9 | (a2-2) | KE-604 | acrylic acid addition pale colred rosin | - | 238 | - | 1.9 | 401 | 0.0047 |

In the Table, "AV" means an acid value, "OHV" means a hydroxyl value (each unit is mgKOH/g) and "wt%" shows a content weight of ingredients having a molecular weight of 300 or less, and "K" means a softening point of.

### EXAMPLES 1 to 25 and COMPARATIVE EXAMPLES 1 to 4

### (Evaluation of "void(s) appear within solder joint" and "solder-balling")

### (Preparation of Solder Paste)

Fluxes were prepared by the compositions as shown in Tables 2-6. Then, a Sn-Ag-Cu type solder powder (Sn 96.5 wt%, Ag 3 wt%, Cu 0.5 wt%; product name "Sn 96.5 /Ag 3/Cu 0.5", Mitsui Mining and Smelting Co., Ltd.) was added to the flux (flux: solder powder =1:9 by weight ratio), and then they were kneaded together with a planetary mill for 1 hour, results solder pastes.

### (Soldering (bump formation))

The above obtained solder paste was deposited on a test substrate board for bump formation (220 µm pitch). Then, soldering was carried out in a nitrogen reflow. The resultant substrate was used as test piece. Printing conditions were as follows. The diameter of each of bumps is about 100 µm in average.

### <Printing Conditions>

Metal Mask: a laser processed product of 70 µm thickness
Metal Squeezing rate: 20 mm/sec.
Mask-release rate: 0.1 mm/sec.

### <Reflow Profiles>

Preheat: 150-160°C for 90 sec.
Peak temperature in reflow: 235°C
Reflow conditions: 220°C or higher for about 30 sec.

### (Observation of "void(s) appear within solder joint")

An X ray was irradiated on each test pieces and "void(s) appear within solder joint" in the solder bumps were visually observed. The average diameters (µm) (%) of void(s) in relation to the bump diameter (100 µm) were measured among 378 bumps. Evaluations of "void(s) appear within solder joint" are as the following standard.
⊚: average of not higher than 10 %
○:average of higher than 10 % and not higher than 15 %
○Δ:average of higher than 15 % and not higher than 20 %
Δ:average of higher than 20 % and not higher than 25 %
Δ × :average of higher than 25 % and not higher than 30 %
× :average of higher than 30 %

In each Tables 4 to 6, the symbol with "+" in each row of "void(s) appear within solder joint" means that the evaluation is smaller than an intermittent value between the upper value and lower value of a symbol mentioned above, and the symbol with "-" means the evaluation is smaller than an intermittent value between the upper value and lower value of a symbol mentioned above.

### (Observation of solder ball(s))

On each test pieces prepared for observing "void(s) appear within solder joints" as mentioned above, solder ball(s) about a solder bump was counted through a microscope (product name "VH-8000", KEYENCE Corp.) at 200 times magnification, and the average number was calculated among bumps. Evaluation was conducted according to the following standard.
○:0
○Δ: 1-3
Δ: 3-5
Δ×: 6-9
× : not less than 10

**TABLE 2**

| Flux ingredient | | Ex. 1 | Ex. 2 | Ex. 3 | Ex. 4 | Ex. 5 | Ex. 6 | Ex. 7 |
|---|---|---|---|---|---|---|---|---|
| Base resin (A) | Ester (a1-6) | 9.9 | 21.2 | 35.7 | 34.8 | 53.5 | 34.8 | 9.9 |
| | (residue^{*1}) | (0.4) | (0.8) | (1.4) | (1.4) | (2.1) | (1.4) | (0.4) |
| | Resin acid (a2- 1) | 5.1 | 11.1 | 9.3 | 18.2 | 5.1 | 0 | 0 |
| | Resin acid (a2-2) | 0 | 0 | 0 | 0 | 0 | 18.2 | 5.1 |
| | Others^{*2} | 0 | 0 | 0 | 0 | 0 | 0 | 0 |
| Activator (B) | Adipic acid | 1.0 | 1.0 | 1.0 | 1.0 | 1.0 | 1.0 | 1.0 |
| | Silver diethylamine hydrobromide | 1.0 | 1.0 | 1.0 | 1.0 | 1.0 | 1.0 | 1.0 |
| Additive (C) (thixotropic agent) | Hydrogenated castor oil | 8.0 | 8.0 | 8.0 | 8.0 | 8.0 | 8.0 | 8.0 |
| Solvent (D) | Hexyl carbitol | 74.6 | 56.9 | 43.6 | 35.6 | 29.3 | 35.6 | 74.6 |
| "void(s) appear within solder joints" | | ⊚ | ○ | ○Δ | Δ | Δ | Δ | ⊚ |
| Solder ball | | Δ× | ○ | ○ | ○ | ○Δ | ○ | Δ× |

In Tables 2 and 3, *1 "residue" means unreacted product (including resin acid, etc.), and as the *2 "others", a China WW rosin (having an acid value around 168 mgKOH/g and a softening point around 74°C) is used. Each numbers in the highest row within the "Base resin (A)" row is the weight percent of the ester compound itself (pure ingredient). These meanings are same in the following Tables.

**TABLE 3**

| Flux ingredient | | Com. Ex. 1 | Com. Ex. 2 | Com. Ex. 3 | Com. Ex. 4 |
|---|---|---|---|---|---|
| Base resin (A) | Ester (a1-1) | 0 | 0 | 3.0 | 60 |
| | (residue^{*1}) | - | - | (0.1) | (2.3) |
| | Resin acid (a2-1) | 46.8 | 15.6 | 11.1 | 5.1 |
| | Resin acid (a2-2) | 0 | 0 | 0 | 0 |
| | Others^{*2} | 0 | 31.2 | 0 | 0 |
| Activator(B) | Adipic acid | 1.0 | 1.0 | 1.0 | 1.0 |
| | Silver diethylamine hydrobromide | 1.0 | 1.0 | 1.0 | 1.0 |
| Additive (C) (thixotropic agent) | Hydrogenated castor oil | 8.0 | 8.0 | 8.0 | 8.0 |
| Solvent (D) | Hexyl carbitol | 43.2 | 43.2 | 75.8 | 22.6 |
| "void(s) appear within solder joints" | | × | × | Δ× | Δ× |
| Solder ball | | Δ | Δ | × | × |

**TABLE 4**

| Flux ingredient | | Ex. 4 | Ex. 8 | Ex. 9 | Ex. 6 | Ex. 10 | Ex. 11 |
|---|---|---|---|---|---|---|---|
| Base resin (A) | Ester (a1) or | (a1-6) | (a1'-6) | (a1'-6) | (a1-6) | (a1'-6) | (a1'-6) |
| | Ester (a1') | 36.2 | 36.2 | 36.2 | 36.2 | 36.2 | 36.2 |
| | Resin acid (a2) or | (a2-1) | (a2-1) | (a2'-1) | (a2-2) | (a2-2) | (a2'-2) |
| | Resin acid (a2') | 18.2 | 18.2 | 18.2 | 18.2 | 18.2 | 18.2 |
| Activator(B) | Adipic acid | 1.0 | 1.0 | 1.0 | 1.0 | 1.0 | 1.0 |
| | Silver diethylamine hydrobromide | 1.0 | 1.0 | 1.0 | 1.0 | 1.0 | 1.0 |
| Additive (C) (thixotropic agent) | Hydrogenated castor oil | 8.0 | 8.0 | 8.0 | 8.0 | 8.0 | 8.0 |
| Solvent (D) | Hexyl carbitol | 35.6 | 35.6 | 35.6 | 35.6 | 35.6 | 35.6 |
| "void(s) appear within solder joints" | | Δ | Δ+ | ○Δ | Δ | Δ+ | ○Δ |
| Solder ball | | ○ | ○ | ○ | ○ | ○ | ○ |

**TABLE 5**

| Flux ingredient | | Ex. 4 | Ex. 12 | Ex. 13 | Ex. 14 | Ex. 15 | Ex. 16 | Ex. 17 |
|---|---|---|---|---|---|---|---|---|
| Base resin (A) | Ester (a1) | (a1-6) | (a1-1) | (a1-2) | (a1-5) | (a1-7) | (a1-8) | (a1-9) |
| | | 36.2 | 36.2 | 36.2 | 36.2 | 36.2 | 36.2 | 36.2 |
| | Resin acid (a2) | (a2-1) | (a2-1) | (a2-1) | (a2-1) | (a2-1) | (a2-1) | (a2-1) |
| | | 18.2 | 18.2 | 18.2 | 18.2 | 18.2 | 18.2 | 18.2 |
| Activator (B) | Adipic acid | 1.0 | 1.0 | 1.0 | 1.0 | 1.0 | 1.0 | 1.0 |
| | Silver diethylamine hydrobromide | 1.0 | 1.0 | 1.0 | 1.0 | 1.0 | 1.0 | 1.0 |
| Additive (C) (thixotropic agent) | Hydrogenated castor oil | 8.0 | 8.0 | 8.0 | 8.0 | 8.0 | 8.0 | 8.0 |
| Solvent (D) | Hexyl carbitol | 35.6 | 35.6 | 35.6 | 35.6 | 35.6 | 35.6 | 35.6 |
| "void(s) appear within solder joints" | | Δ | Δ- | Δ- | Δ | Δ | Δ | Δ+ |
| Solder ball | | ○ | ○ | ○ | ○ | ○ | ○ | ○ |

**TABLE 6**

| Flux ingredient | | Ex. 7 | Ex. 18 | Ex. 19 | Ex. 20 | Ex. 21 | Ex. 22 | Ex. 23 | Ex. 24 | Ex. 25 |
|---|---|---|---|---|---|---|---|---|---|---|
| Base resin (A) | Ester (a1') | (a1'-6) | (a1'-1) | (a1'-2) | (a1'-3) | (a1'-4) | (a1'-5) | (a1'-7) | (a1'-8) | (a1'-9) |
| | | 36.2 | 36.2 | 36.2 | 36.2 | 36.2 | 36.2 | 36.2 | 36.2 | 36.2 |
| | Resin acid (a2) | (a2-1) | (a2-1) | (a2-1) | (a2-1) | (a2-1) | (a2-1) | (a2-1) | (a2-1) | (a2-1) |
| | | 18.2 | 18.2 | 18.2 | 18.2 | 18.2 | 18.2 | 18.2 | 18.2 | 18.2 |
| Activator (B) | Adipic acid | 1.0 | 1.0 | 1.0 | 1.0 | 1.0 | 1.0 | 1.0 | 1.0 | 1.0 |
| | Silver diethylamine hydrobromide | 1.0 | 1.0 | 1.0 | 1.0 | 1.0 | 1.0 | 1.0 | 1.0 | 1.0 |
| Additive (C) (thixotropic agent) | Hydrogenated castor oil | 8.0 | 8.0 | 8.0 | 8.0 | 8.0 | 8.0 | 8.0 | 8.0 | 8.0 |
| Solvent (D) | Hexyl carbitol | 35.6 | 35.6 | 35.6 | 35.6 | 35.6 | 35.6 | 35.6 | 35.6 | 35.6 |
| "void(s) appear within solder joints" | | Δ+ | Δ+ | Δ+ | Δ+ | Δ+ | Δ+ | Δ+ | Δ+ | ○ |
| Solder ball | | ○ | ○ | ○ | ○ | ○ | ○ | ○ | ○ | ○ |

### EXAMPLES 26 to 30

### (Evaluation of "void(s) appear at the interface of solder-metal")

### (Preparation of Solder Paste)

Each fluxes of Example 26 to Example 30 was prepared with the ingredients and their amount both listed in Table 7. The solder powder, the planetary mill, and kneading time were the same as above.

### (Soldering)

Each solder pastes of Example 26 to Example 30 was applied in 0.15 mm thickness on a copper substrate board for direct bonding (a ceramic board with 20 mm × 30 mm copper foil by screen printing with a mask and a squeeze, and the copper substrate board was used as a test piece. The printing conditions are as follows.

### <Reflow Profiles for observation of "void(s) appear at the interface of solder-metal">

Preheat: 160-180°C for 80 sec.
Peak temperature in reflow: 240°C, 220°C or higher for about 30 sec.

### (Observation of "void(s) appear at the interface of solder-metal")

The voids appeared at an interface of solder joints were visualized by an X ray irradiation. A ratio of a surface area (mm²) of the said "void(s) appear at the interface of solder-metal" to a plain electrode surface area (mm²) was obtained. The evaluation is based on the following standard.
○: not more than 5 %
Δ: more than 5 % and not more than 10 %

**TABLE 7**

| Flux ingredient | | Ex. 26 | Ex. 27 | Ex. 28 | Ex. 29 | Ex. 30 |
|---|---|---|---|---|---|---|
| Base resin (A) | Ester (a1) or | (a1-6) | (a1'-6) | (a1'-6) | (a1-6) | (a1'-6) |
| | Ester (a1') | 36.2 | 36.2 | 36.2 | 36.2 | 36.2 |
| | Resin acid (a2) or | (a2-1) | (a2-1) | (a2'-1) | (a2-2) | (a2-2) |
| | Resin acid (a2') | 18.2 | 18.2 | 18.2 | 18.2 | 18.2 |
| Activator (B) | Adipic acid | 1.0 | 1.0 | 1.0 | 1.0 | 1.0 |
| | Silver diethylamine hydrobromide | 1.0 | 1.0 | 1.0 | 1.0 | 1.0 |
| Additive (C) (thixotropic agent) | Hydrogenated castor oil | 8.0 | 8.0 | 8.0 | 8.0 | 8.0 |
| Solvent (D) | Hexyl carbitol | 35.6 | 35.6 | 35.6 | 35.6 | 35.6 |
| "void(s) appear at the interface of solder-metal" | | Δ | ○ | ○ | Δ | ○ |

### INDUSTRIAL APPLICABILITY

According to the present invention, a flux for a lead-free solder that is able to reduce "void(s) appear within solder joint", "void(s) appear at the interface of solder-metal", and "solder-balling" without impairing general solderabilities can be provided. Further, in a solder paste using the flux of the present invention provides a very small number of void(s) or a very small amount thereof, and thus it can advantageously be used for conventional surface mounting.

## Claims

1. A flux for a lead-free solder, which comprises 6-55 wt% of a polyvalent alcohol ester of a resin acid (a1) as a base resin (A).

2. The flux for a lead-free solder of Claim 1, wherein the above ester (a1) is prepared to have a ratio (wt%/K) equal to 0.004 or less, wherein the (wt%) is a content weight of components having a molecular weight equal to 300 or less in the ester (a1), and the (K) is a softening point of the same ester (a1).

3. The flux for a lead-free solder of Claim 1 or 2, wherein a resin acid comprising the above ester (a1) is a Diels-Alder adduct of an α,β-unsaturated carboxylic acid and a resin acid.

4. The flux for a lead-free solder of Claim 1, 2 or 3, further comprising a resin acid (a2) as the base resin (A).

5. The flux for a lead-free solder of Claim 4, wherein the above resin acid (a2) is prepared to have a ratio (wt%/K) equal to 0.004 or less, wherein the (wt%) is a content weight of components having a molecular weight equal to 300 or less in the same resin acid (a2), and the (K) is a softening point of the same resin acid (a2)

6. The flux for a lead-free solder of the Claim 4 or 5, wherein the above resin acid (a2) is a polymerized rosin and/or a Diels-Alder adduct of an α,β-unsaturated carboxylic acid and a resin acid.

7. The flux for a lead-free solder of Claim 4, 5 or 6, wherein a total solid content weight of the above ester (a1) and the above resin acid (a2) is 10-60 wt%.

8. The flux for a lead-free solder of Claim 4, 5, 6 or 7, wherein a solid content weight of the said ester (a1) in a total solid content weight of the above ester (a1) and the above resin acid (a2) is 60-88 wt%.

9. The flux for a lead-free solder of Claim 1, 2, 3, 4, 5, 6, 7 or 8, further comprising an activator (B), an additive (C) and a solvent (D).

10. The flux for a lead-free solder of Claim 1, 2, 3, 4, 5, 6, 7, 8 or 9, wherein the above polyvalent alcohol is a di- or more valent alcohol.

11. The flux for a lead-free solder of Claim 1, 2, 3, 4, 5, 6, 7, 8 or 9, wherein the above polyvalent alcohol is a trivalent alcohol and/or a tetravalent alcohol.

12. The flux for a lead-free solder of Claim 1, 2, 3, 4, 5, 6, 7, 8 or 9, wherein the above polyvalent alcohol is glycerin and/or pentaerythritol.

13. A solder paste, which comprises the flux for a lead-free solder of Claim 1, 2, 3, 4, 5, 6, 7, 8, 9, 10, 11 or 12, and a lead-free solder powder.
